# EUROPEAN PATENT SPECIFICATION

(11) **EP 2 493 701 B1**
(45) Date of publication and mention of the grant of the patent: **10.09.2014**
(21) Application number: 10775857.5
(22) Date of filing: 29.10.2010
(51) Int. Cl.: B42D 15/00, B44F 1/10

(54) **SECURITY DEVICE**
VERBESSERTE SICHERHEITSVORRICHTUNGEN
AMÉLIORATIONS DANS DES DISPOSITIFS DE SÉCURITÉ

(30) Priority: 30.10.2009 GB 0919138
(43) Date of publication of application: 05.09.2012
(73) Proprietor: De La Rue International Limited, Basingstoke RG22 4BS (GB)
(72) Inventor: LISTER, Adam, Andover Hampshire SP10 2ND (GB)
(74) Representative: Boult Wade Tennant
(86) International application number: PCT/GB2010/002008
(87) International publication number: WO 2011/051682

(56) References cited:
- DE-A1-102008 009 296
- GB-A- 2 442 711

## Description

The present invention relates to improvements in security devices that can be used in for various authenticating or security applications, and in particular to an optically variable security device utilising multiple colour shift layers.

The increasing popularity of colour photocopiers and other imaging systems and the improving technical quality of colour photocopies has led to an increase in the counterfeiting of banknotes, passports and identification cards and the like. There is, therefore, a need to add additional authenticating or security features to existing security features. Steps have already been taken to introduce optically variable features into substrates used in such documentation that cannot be reproduced by a photocopier. There is also a demand to introduce features which are discernible by the naked eye but which are "invisible" to, or viewed differently, by a photocopier. Since a photocopying process typically involves scattering high-energy light off an original document containing the image to be copied, one solution would be to incorporate one or more features into the document which have a different perception in reflected and transmitted light, an example being watermarks and enhancements thereof.

It is known that certain liquid crystal materials exhibit a difference in colour when viewed in transmission and reflection, as well as an angularly dependent coloured reflection. Liquid crystal materials have been incorporated into security documents, identification cards and security elements with a view to creating distinctive optical characteristics. EP-A-0435029 is concerned with a data carrier, such as an identification card, which comprises a liquid crystal polymer layer or film in the data carrier. The liquid crystal polymer is solid at room temperature and is typically held within a laminate structure. The intention is that the liquid crystal layer, which is applied to a black background, will demonstrate a high degree of colour purity in the reflected spectrum for all viewing angles. Automatic testing for verification of authenticity is described using the wavelength and polarization properties of the reflected light in a single combined measurement. This has the disadvantage of being optically complex using a single absolute reflective measurement requiring a uniform liquid crystal area on a black background.

AU 488,652 B is also concerned with preventing counterfeit copies by introducing a distinctive optically-variable feature into a transparent window security element. This document discloses the use of a liquid crystal "ink" laminated between two layers of plastic sheet. The liquid crystal is coated on a black background so that only the reflected wavelengths of light are seen as a colour. The security feature is primarily provided by thermochromic liquid crystal materials, which have the characteristic of changing colour with variation in temperature.

Liquid crystal materials can be incorporated into security devices either as a film, as for example in WO-A-03061980, or in the form of an ink as a liquid crystal pigment in an organic binder, as for example in EP-A-1156934. The advantage of a liquid crystal ink is that it can be applied using conventional printing processes and therefore it is relatively straightforward to apply the liquid crystal material in the form of a design. However the colour purity, brightness and sharpness of the observed colour and colour-shift are significantly degraded for a pigmented liquid crystal ink compared to a liquid crystal film. This degradation is due to the variability in alignment of the cholesteric helical axis between the individual liquid crystal pigments compared to the uniform alignment of the liquid crystal film.

A method of increasing the range of available colours in liquid crystal films is described in US 4,893,906, in which two or more liquid crystal coatings are overlaid to obtain new colours as a result of the colour additive properties of the liquid crystal coatings which do not absorb light. WO-A-2005105474 describes a security device comprising two superimposed cholesteric liquid crystal layers in which the additive mixing of the colours permits a wider range of colourshift effects. In some of the embodiments in WO-A-200510546 regions exhibiting different colourshifting effects are created by a partial application of one of the liquid crystal layers in localised areas. A partial application of a liquid crystal film is not straightforward and increases significantly the complexity of the production process compared to simply applying one uniform film over a second uniform film.

WO-A-2008/043981 (GB 2 442 711 A) describes an improved security device which incorporates two layers of optically variable liquid crystal materials which have different reflective properties and a partial layer of a light absorbing material between the liquid crystal layers. This creates two optically variable regions having a different appearance.

This document further describes (see in particular page 12, line 25 - page 13, line 4; page 18, line 6 - page 19, line 9; figures 5, 12) a security device comprising a first colourshifting layer (13), a second colourshifting layer (12) which exhibits different reflective characteristics to the first colourshifting layer, said colourshifting layers exhibiting a visible colour at normal incidence, a partial first light absorbing layer (14) between first surfaces of the first and second colourshifting layers and a second light absorbing layer (15) applied to a second surface of the second colourshifting layer. This document also discloses that both regions A and B can have the same colour (p. 18 line 6-p. 19 line 9), not because of a matching of colours, but because the second colourshifting layer is transparent. However this document discloses no multilayer polymer as colourshifting layer. D2 suggests explicitly to use colours other than black for the light absorbing layer (p. 12 line 25-p. 13 line 4).

It has been found that multilayer polymer films provide a colourshift effect which is comparable to that of liquid crystals, yet are sufficiently strong to be self supporting. Such films are described in EP-A-1047549, US-B-5089318 and WO-A-9619347 and are formed of multiple layers (hundreds or thousands) of at least two different materials. The various layers may have different actual and/or optical thickness and different indices of refraction. These films contain no dye or pigment or other element which may fade in time, as they just use selective reflection to provide the colourshift effect. As incident white lights strikes the film, light of a specific wavelength is reflected whilst other wavelengths are transmitted through the layers to be reflected at different angles to the normal. Thus when viewed at different angles of light different colours can be seen.

As described in EP-A-1047549 the layers may be selected so that light in the non-visible (infra-red) part of the electromagnetic spectrum is reflected at normal incidence, and the film thus appears substantially transparent. As the film is tilted away from normal it reflects a visible colour (e.g. red).

The document DE 10 2008 009296 A1, which is seen as the closest state of the art, discloses (see in particular paragraphs [0022], [0 27], [0 55] - [0061]; figures 6, 7) a security device comprising a first colourshifting layer (60), a second colourshifting layer (30) which exhibits different reflective characteristics to the first colourshifting layer, said second colourshifting layer exhibiting a visible colour at normal incidence, a partial first light absorbing layer (52) between first surfaces of the first and second colourshifting layers, wherein the colour of the partial first absorbing layer is selected to substantially match the colour of light reflected at a normal angle of incidence by the second colourshifting layer (§22, 27, 55, 56). This document further discloses a reflective layer (32), not a second light absorbing layer. The first colourshifting layer (60) does not exhibit a visible colour at normal incidence, but is transparent (§58-60, fig. 6 and 7b). This document discloses no multilayer polymer as colourshifting layer.

It is an object of the present invention to provide an improved optically variable security device which has a distinctive and easily recognisable colourshifting security feature.

The present invention provides a security device comprising a first colourshifting layer, a second colourshifting layer which exhibits different reflective characteristics to the first colourshifting layer, said colourshifting layers exhibiting a visible colour at normal incidence, a partial first light absorbing layer between first surfaces of the first and second colourshifting layers and a second light absorbing layer applied to a second surface of the second colourshifting layer, wherein the colour of the partial first absorbing layer is selected to substantially match the colour of light reflected at a normal angle of incidence by the combination of the second colourshifting layer and the second absorbing layer.

The present invention further provides a security device comprising a first colourshifting layer, a second colourshifting layer which exhibits different reflective characteristics to the first colourshifting layer, said second colourshifting layer being a multilayer polymer film, a partial first light absorbing layer between first surfaces of the first and second colourshifting layers and a second light absorbing layer applied to a second surface of the second colourshifting layer, wherein the colour of the partial first absorbing layer is selected to substantially match the colour of light reflected at a normal angle of incidence by the combination of the second colourshifting layer and the second absorbing layer.

A preferred embodiment of the present invention will now be described, by way of example only, with reference to the accompanying drawings, in which:-
Figure 1 is a plan view of a security document incorporating a partially embedded security device of the present invention;
Figure 2a is a cross-sectional side elevation of a security device of the present invention;
Figures 2b and 2c are plan views of another embodiment of a security device of the present invention when viewed in reflective light at normal incidence and tilted away from normal incidence respectively;
Figure 2d is a cross sectional side elevation of yet another embodiment of the present invention;
Figures 3 and 4 are plan views of an alternative embodiment of the present invention viewed in reflected light at normal incidence and tilted away from normal incidence respectively.

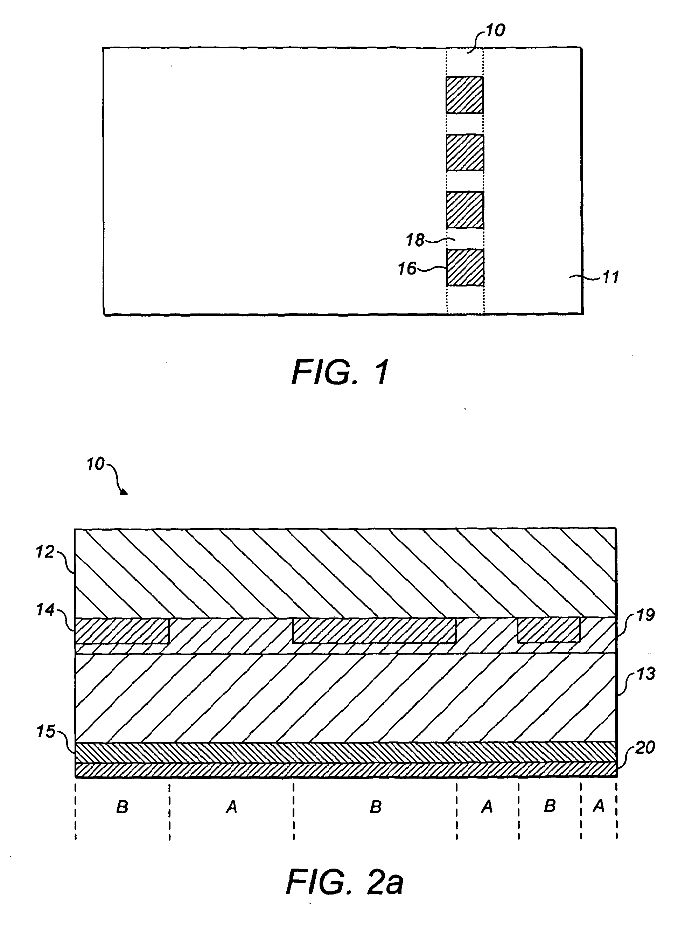

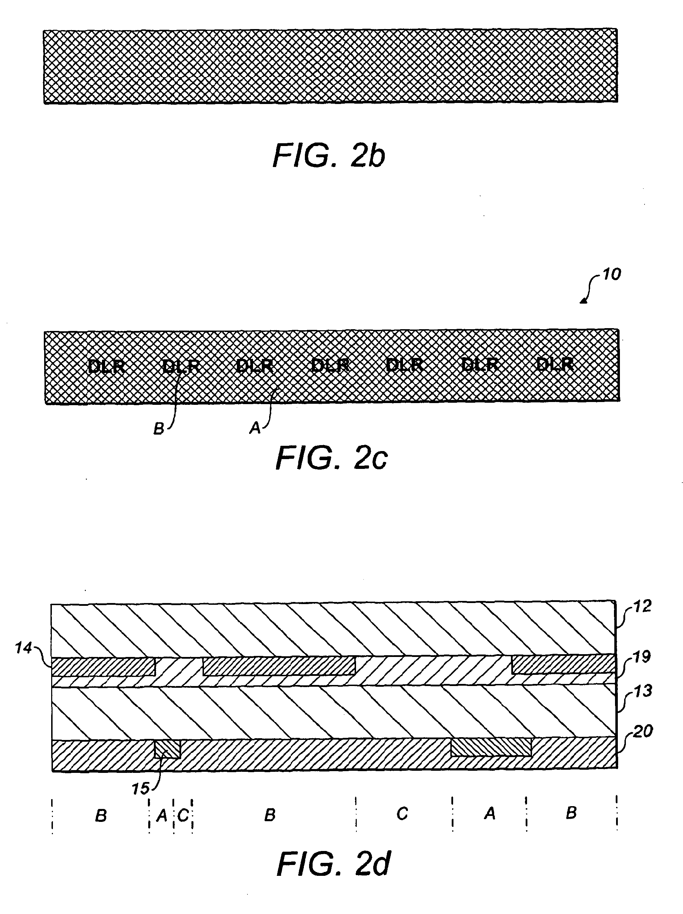

Referring to Figure 1, the present invention provides a security device 10 for protecting a document of value 11. As shown in Figure 2, the security device 10 comprises a first colourshifting layer 12 and a second colourshifting layer 13 which exhibits different reflective characteristics to the first colourshifting layer 12. A first partial layer 14 of a light absorbing material is applied between the first and second colourshifting layer 12, 13 and a second layer 15 of a light absorbing material is applied to the exposed surface of the second colourshifting layer 13.

The security device 10 can be incorporated into secure documents 11 in any of the conventional formats known in the prior art, for example as patches, foils, stripes, strips or threads. The security device 10 can be arranged either wholly on the surface of the document 11, as in the case of a stripe or patch, or can be visible only partly on the surface of the document 10 in the form of a windowed security thread. Security threads are now present in many of the world's currencies as well as vouchers, passports, travellers' cheques and other documents. In many cases the thread is provided in a partially embedded or windowed fashion where the thread appears to weave in and out of the paper and is visible in windows 16 in one or both surfaces of the document 11. One method for producing paper with so-called windowed threads can be found in EP-A-0059056. EP-A-0860298 and WO-A-03095188 describe different approaches for the embedding of wider partially exposed threads into a paper or other substrate. Wide threads, typically having a width of 2-6mm, are particularly useful as the additional exposed thread surface area allows for better use of optically variable devices, such as that used in the present invention. Figure 1 shows the security device 10 of the present invention incorporated into a security document 11 as a windowed thread with windows 16 in which the security document 10 is exposed and areas 18 in which the security device is embedded within the substrate of the document 11.

In a further embodiment of the invention (not shown) the device 10 is incorporated into the document 11 such that regions of the device 10 are viewable from both sides of the document 11. Methods of incorporating a security device such that it is viewable from both sides of the document 11 are described in EP-A-1141480 and WO-A-03054297. In the method described in EP-A-1141480 one side of the device 10 is wholly exposed at one surface of the substrate in which it is partially embedded, and partially exposed in windows 11 at the other surface of the substrate.

In the case of a stripe or patch, the security device 10 may be prefabricated on a carrier strip 17 and transferred to the substrate in a subsequent working step. The security device 10 can be applied to the document using an adhesive layer, which is applied either to the security device 10 or the surface of the security document 11 to which the device 10 is to be applied. After transfer, the carrier strip 17 is removed leaving the security device 10 exposed. Alternatively the carrier strip 17 can be left in place to provide an outer protective layer.

Following the application/incorporation of the security device 10 the security document 11 generally undergoes further standard security printing processes including one or more of the following; wet or dry lithographic printing, intaglio printing, letterpress printing, flexographic printing, screen-printing, and/or gravure printing. In a preferred embodiment, and to increase the effectiveness of the security device 10 against counterfeiting, the design of the security device 10 can be linked to the document 11 it is protecting by content and registration to the designs and identifying information provided on the document 11.

Although all types of colourshifting materials and structures may be used in the present invention, including inter alia liquid crystals, thin film interference structures, and photonic crystal structures, a particularly suitable material for the colourshifting layers 12,13 are multilayer polymeric films such as described in EP-A-1047549, US-B-5089318 and WO-A-9619377. The invention is also not limited to the use of films and the layers 12, 13 for example, can be provided by pigmented coatings for example a pigmented liquid crystal coating applied to a carrier strip of a suitable polymeric substrate such as Polyethylene Terephthalate (PET) or Bi-axially oriented polypropylene (BOPP).

Liquid crystal films which would be suitable for use in the present invention would generally have a 20-25% light reflectance, although this is polarisation selective so a maximum 50% is achievable. Multilayer polymeric films generally have higher light reflectances and can be greater than 50%, and even approaching 100%. This means that the latent image and colourshift effects will be brighter for such films over liquid crystal.

The chemical mechanical durability of multilayer polymeric films is also better than that of liquid crystal films. In particular the liquid crystal films can be frangible, unless protected by additional protective layers, making them vulnerable to physical hazards when security documents incorporating them are in circulation. However the addition of extra layers adds to the cost and time of production and adds additional bulk to the device 10.

When light strikes the colourshifting layers 12,13, some of the light is reflected. The wavelength of the reflected light depends on the structure and composition of the colourshift material/structure and the reflected light will appear coloured. The wavelength of the reflected light is also dependent on the angle of incidence, which results in a colour change perceived by the viewer as the colourshifting layer is tilted away from the normal.

In all of the embodiments now to be described in the colourshifting layer is a multilayer polymeric film which is typically self-supporting and does not require the use of a carrier substrate. If a colourshifting film is used which is not self-supporting, then a polymeric base film may be used as a carrier film.

In one embodiment of the invention the first colourshifting layer 12 is a multilayer polymeric film of alternating layers of polyester and polymethylmethacrylate, and selected to have approximately 140 to 150 layers, each layer having a thickness of approximately 0.1 microns, resulting in a total film thickness of approximately 15 microns. In this example the film 12 exhibits a green colour when viewed along normal incidence and shifts to blue as the viewing direction is changed away from normal incidence.

The partial absorbing layer 14 is applied to one surface of the film 12, preferably by printing an ink using a suitable printing method such as gravure, screen, flexographic or lithographic printing, and preferably in the form of a design.

A laminating adhesive 19 is applied over the partial absorbing layer 14 and the exposed regions of the first fist colourshifting layer 12 to enable the second colourshifting layer 13 to be laminated thereto. The second colourshifting layer 13 is different from the first colourshifting layer 12 and has a different colourshift effect, for example exhibiting a red to green colourshift as the viewing angle is changed away from normal incidence.

A second, preferably full, layer 15 of light absorbing material is then applied, again preferably by gravure or another suitable printing process, to the exposed surface of the second layer 13, i.e. the opposing surface to the one brought into contact with the adhesive 19.

In other embodiments the second light absorbing material may also be applied in the form of a pattern or design.

The absorbing layers 14,15 of the present invention may comprise a pigmented ink or coating or alternatively a non-pigmented absorbing dye can be used. They may also comprise magnetic ink. The colour of the first absorbing layer 14 is selected to match the normally reflected colour of the second colourshifting layer 13 when viewed against the second absorbing layer 15. Thus if the second colourshifting layer 13 is red to green and the second absorbing layer 15 is black, the normally reflected colour will be dark red and that is the colour selected for the first absorbing layer 14.

In order to improve the appearance of the reverse side of the security device 10 a full metal layer 20 may be applied thereto by printing with a metal or metal effect ink, for example an aluminium loaded ink. Alternatively a metal layer may be deposited using an evaporating technique.

Adhesive layers 19 may be applied to the outer surfaces of the device 10 to improve adherence to the secure document 11.

The application of a partial absorbing layer 14 between the two colourshifting layers 12,13 creates two optically variable regions, Regions A and B. In Region A there is no absorbing layer between the two colourshifting layers 12,13 such that the wavelength of reflected light, at any given angle of incidence, is a result of the additive mixing of the individual wavelengths of light reflected from the two colourshifting layers 12,13. In this example where layer 12 exhibits a green to blue colourshift and layer 13 exhibits a red to green colourshift the reflected light from Region A will appear yellow from the combination of green and red. In Region B there is an absorbing layer 14, which in this example is red, between the two multilayer films 12,13 and the wavelength of reflected light, at any given angle of incidence, is solely the reflected light from the second multilayer film 13 as influenced by the colour of the underlying regions of the partial absorbing layer 14. As the colour of the first absorbing layer 14 matches the colour of the light reflected by the combination of the second colourshifting layer and the second absorbing layer 15, the security device 10 has a uniform yellow appearance at normal incidence.

However, when the security device 10 is tilted at an angle away from normal, (i.e. the viewing angle is changed away from normal incidence), the first colourshifting layer 12 now reflects blue light, which will appear as magenta in regions B when viewed over the underlying regions of the red absorbing layer 14. The second colourshifting layer 15 reflects green light, so the regions A will appear turquoise as a result of the additive mixing of the individual wavelengths of the blue and green light reflected from the two colourshifting layers 12,13 respectively.

Consequently the security device 10 has a latent security feature which is not visible when the device is viewed at a normal angle of incidence. However a plurality of magenta regions B corresponding to the partial absorbing layer 14 will become visible in a turquoise background. A plan view of a typical security device is shown in Figures 2b and 2c. In this case the partial absorbing layer 14 forms the characters "DLR" (region B) and the background is provided by region A. When viewing at normal incidence regions A and B appear yellow and the characters "DLR" are hidden. On changing the viewing angle away from normal incidence the "DLR" characters change from yellow to magenta and the background region changes from yellow to turquoise resulting in the revealing of the "DLR" characters.

In another embodiment of the invention shown in Figure 2d the second absorbing layer 15 under the second film 13 may be applied in the form of a design, creating a further optically variable Region C. In Region C there is no absorbing layer under either of the films 12,13, and when the device 10 is positioned on a reflective background, the intensity of the transmitted colour reflected back through the films 12,13 saturates the reflective colour. The transmitted and reflected colours are complementary, for example, a red to green colourshift in reflection is seen as a cyan to magenta colourshift in transmission. When the security device 10 is applied to a predominantly white substrate, then the light transmitted through Region C gives the underlying substrate a noticeable tint of colour which is the complementary colour to the observed reflected colour in Region A.

The designs generated by the partial application of one or more of the absorbing layers 14,15 are preferably in the form of images such as patterns, symbols and alphanumeric characters and combinations thereof. The designs can be defined by patterns comprising solid or discontinuous regions which may include for example line patterns, fine filigree line patterns, dot structures and geometric patterns. Possible characters include those from non-Roman scripts of which examples include but are not limited to, Chinese, Japanese, Sanskrit and Arabic.

In a further embodiment one or both of the films 12,13 is a partial layer. Where the second film 13, for example, is a partial layer, such that in certain regions the first film 12 is exposed, then a further optically variable region can be created in which the wavelength of reflected light, at any given angle of incidence, is solely the reflected light from the first film 12.

The use of a multilayer polymer film as the second colourshifting layer 13, where only one component of the colourshift is in the visible region of the electromagnetic spectrum, also enables a latent image to be incorporated into the device 10 that only becomes apparent at certain angles of view.

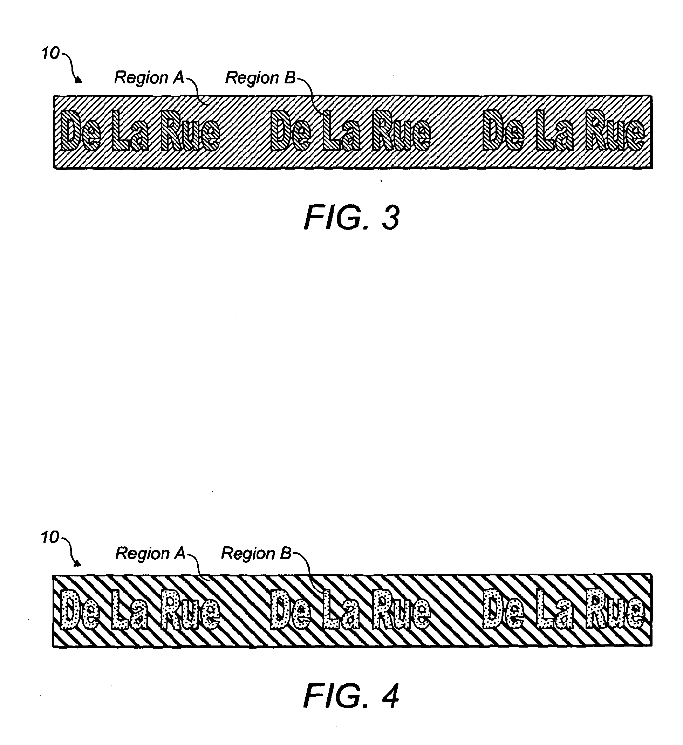

Thus the colour of the first partial absorbing layer 14 will need to be identical to the colour of the second absorbing layer 15 in order for it to match the reflected "colour" from the second layer 13 and second absorbing layer 15. In one example, illustrated in Figures 3 and 4, and referring to the cross-section in Figure 2a, the second layer 13 reflects light in the infrared region of the electromagnetic spectrum when at normal incidence (Figure 3), which is colourless and transparent, and reflects red light when tilted away from normal incidence (Figure 4). The first film 12 exhibits a green-blue colourshift and when viewed at normal incidence over a dark background, this brings out a strong dark green colour.

Regions A and B are defined by the partial black absorbing layer 14 between the two films 12, 13 which, in this example, is applied in the form of alphanumeric characters such that Region B is a repeating pattern of the words DE LA RUE (RTM) and Region A is the background. When viewed in reflection at normal incidence both Regions A and B will appear dark green due to the transparent colourless appearance of the second film 13 having no visible effect on the appearance of the device 10. On tilting the device 10 such that it is viewed away from normal incidence Region A appears magenta, due to the additive colour mixing from the blue reflected light from the film 12 and the red reflected light from the second film 13, and Region B appears blue due to the reflected light coming solely from the first film 12. To the authenticator the device 10 appears uniformly green at normal incidence but on tilting away from normal incidence the repeating legend DE LA RUE appears in a magneta colour against a blue background.

The security device 10 can be used in combination with existing approaches for the manufacture of threads. Examples of suitable methods and constructions that can be used include, but are not limited to, those cited within WO-A-03061980, EP-A-516790, WO-A-9825236, and WO-A-9928852.Security devices comprising colourshifting layers such as multilayer polymer films are machine-readable using a spectrophotometer. The machine readable-aspect of the security device 10 of the present invention can be extended further by the introduction of detectable materials in the absorbing layers 14,15 or by the introduction of separate machine-readable layers. Detectable materials that react to an external stimulus include but are not limited to fluorescent, phosphorescent, infrared absorbing, thermochromic, photochromic, magnetic, electrochromic, conductive and piezochromic materials. In one preferred embodiment, the pigment in one of the absorbing layers 14,15 is machine readable, for example carbon black, to produce a machine-readable or conducting layer. Alternatively it may be a magnetic material, such as magnetite, to produce a machine-readable magnetic layer.

In an alternative machine-readable construction one or more of the absorbing layers 14,15 can be formed using a magnetic pigment, for example magnetite. For example the partial absorbing layer 14 in Figure 2a can be formed from such a magnetic pigment to provide a machine-readable code.

In a further embodiment, only part of the partial absorbing layer 14 in Figure 2a is provided with a magnetic pigment and the remainder is provided with a non-magnetic pigment. If both the magnetic and non-magnetic regions are substantially totally absorbing there will be no visual difference in the liquid crystal layer over the two regions and therefore the format of the code will not be readily apparent.

In an alternative machine-readable embodiment a transparent magnetic layer can be incorporated at any position within the structure of the device 10. Suitable transparent magnetic layers containing a distribution of particles of a magnetic material of a size and distributed in a concentration at which the magnetic layer remains transparent are described in WO-A-03091953 and WO-A-03091952.

As a further alternative, the security device of the current invention may incorporate substrate of a polymeric material, such as Polyethylene Terephthalate (PET) or Bixally Oriented Polypropylene (BOPP). This polymeric substrate may be metallised, for example using vapour deposition and subsequently demetallised to form negative or positive indicia as described for example in EP-A-0319157. Alternatively metallic inks could be used instead of vapour deposited metal layers. A magnetic material in the form of tramlines may be applied along both longitudinal edges of the carrier substrate, which optionally may have been previously metallised. A sui9table magnetic material is FX 1021 supplied by Ferron and this may be applied with a coat weight of, for example, 2-6 gsm. The polymeric substrate with the metallised and/or magnetic layers is then laminated to absorbing layer 15 in the structures shown in Figure 2a. The use of magnetic tramlines in this example is for illustrative purposes only, and the magnetic material may be applied in any design.

In all of the embodiments described, where the finished security document 11 has undergone further standard security printing processes, e.g. litho and intaglio, then the colour and/or design of the images/information on the security device 10 can be correlated to the design of the final

## Claims

1. A security device comprising a first colourshifting layer, a second colourshifting layer which exhibits different reflective characteristics to the first colourshifting layer, said colourshifting layers exhibiting a visible colour at normal incidence, a partial first light absorbing layer between first surfaces of the first and second colourshifting layers and a second light absorbing layer applied to a second surface of the second colourshifting layer, wherein the colour of the partial first absorbing layer is selected to substantially match the colour of light reflected at a normal angle of incidence by the combination of the second colourshifting layer and the second absorbing layer.

2. A security device comprising a first colourshifting layer, a second colourshifting layer which exhibits different reflective characteristics to the first colourshifting layer, said second colourshifting layer being a multilayer polymer, a partial first light absorbing layer between first surfaces of the first and second colourshifting layers and a second light absorbing layer applied to a second surface of the second colourshifting layer, wherein the colour of the partial first absorbing layer is selected to substantially match the colour of light reflected at a normal angle of incidence by the combination of the second colourshifting layer and the second absorbing layer.

3. A security device as claimed in claim 1 or claim 2 in which one or both of the colourshifting layers are partial layers.

4. A security device as claimed in any one of the preceding claims in which the second light absorbing layer is a partial layer.

5. A security device as claimed in any one of the preceding claims in which one or both of the light absorbing layers form indicia.

6. A security device as claimed in claim 5 in which the indicia comprise one or more design, pattern, symbols or alphanumeric characters or a combination thereof.

7. A security device as claimed in any one of the preceding claims in which the light absorbing layers are formed from a pigmented ink or coating, or a non-pigmented dye.

8. A security device as claimed in any one of the preceding claims in which the light reflected by one of the colourshifting layers at certain angles of view is in the non-visible wavelength of the electromagnetic spectrum.

9. A security device as claimed in any one of the preceding claims further comprising a machine readable element in a light absorbing layer or in an independent layer.

10. A security device as claimed in any one of the preceding claims in which one or both of the colourshifting layers are liquid crystal layers.

11. A security device as claimed in any one of claims 1 to 9 in which one or both of the colourshifting layers are multilayer polymer films.

12. A security document comprising a substrate and security device as claimed in any one of the preceding claims.

13. A security document as claimed in claim 12 in which the security device is applied to a surface of the substrate or is at least partially embedded in the substrate and visible in windows in at least one surface of the substrate.

14. A security document as claimed in claim 12 or claim 13 comprising a voucher, passport, banknote, cheque, certificate or other document of value.

15. A security document as claimed in any one of claims 12 to 14 in which the document is printed with identifying information and designs formed by the reflection of light from the much larger films of the security device are linked to the identifying information.

16. A security document as claimed in claim 15 in which the link is by content and/or registration of the designs.

17. A method of manufacturing a security device as claimed in any one of claim 1 to 11 comprising the steps of:-
applying the partial layer of light absorbing material to a first colourshifting layer;
applying the second colourshifting layer to cover the partial absorbing layer and the exposed regions of the first colourshifting layer; and
applying a second layer of light absorbing material to cover an exposed surface of the second colourshifting layer.

18. A method of manufacturing a security device as claimed in claim 17 in which a layer of metal is applied to cover the second layer of light absorbing material.

19. A method of manufacturing a security device as claimed in any one of claims 17 or claim 18 further comprising the step of applying a layer of adhesive to one or both surfaces of the device.

## Patentansprüche

1. Sicherheitsvorrichtung, welche Folgendes aufweist: eine erste farbvariable Schicht, eine zweite farbvariable Schicht, welche unterschiedliche Reflektionseigenschaften im Vergleich zu der ersten farbvariablen Schicht aufweist, wobei die farbvariablen Schichten eine sichtbare Farbe bei senkrechtem Lichteinfall aufweisen, eine erste lichtabsorbierende Teilschicht zwischen ersten Oberflächen der ersten und zweiten farbvariablen Schichten, sowie eine zweite lichtabsorbierende Schicht, welche auf eine zweite Oberfläche der zweiten farbvariablen Schicht aufgebracht ist, **dadurch gekennzeichnet, dass** die Farbe der ersten lichtabsorbierenden Teilschicht so ausgewählt wird, dass sie im Wesentlichen der Farbe des Lichts entspricht, das bei senkrechtem Einfallswinkel durch die Kombination der zweiten farbvariablen Schicht und der zweiten absorbierenden Schicht reflektiert wird.

2. Sicherheitsvorrichtung, welche Folgendes aufweist: eine erste farbvariable Schicht, eine zweite farbvariable Schicht, welche unterschiedliche Reflektionseigenschaften im Vergleich zu der ersten farbvariablen Schicht aufweist, wobei die zweite farbvariable Schicht ein mehrschichtiges Polymer ist, eine erste lichtabsorbierende Teilschicht zwischen ersten Oberflächen der ersten und zweiten farbvariablen Schichten und einer zweiten lichtabsorbierenden Schicht, welche auf eine zweite Oberfläche der zweiten farbvariablen Schicht aufgebracht ist, **dadurch gekennzeichnet, dass** die Farbe der ersten lichtabsorbierenden Teilschicht so gewählt wird, dass sie im Wesentlichen der Farbe des Licht entspricht, das bei senkrechtem Einfallswinkel durch die Kombination der zweiten farbvariablen Schicht und der zweiten absorbierenden Schicht reflektiert wird..

3. Sicherheitsvorrichtung nach Anspruch 1 oder Anspruch 2, in welcher eine oder beide farbvariablen Schichten Teilschichten sind.

4. Sicherheitsvorrichtung nach einem der vorhergehenden Ansprüche, in welcher die zweite lichtabsorbierende Schicht eine Teilschicht ist.

5. Sicherheitsvorrichtung nach einem der vorhergehenden Ansprüche, in welcher eine oder beide lichtabsorbierende Schichten Markierungen bilden.

6. Sicherheitsvorrichtung nach Anspruch 5, in welcher die Markierungen ein oder mehrere Designs, Muster, Symbole oder alphanumerische Zeichen oder eine Kombination davon aufweisen.

7. Sicherheitsvorrichtung nach einem der vorhergehenden Ansprüche, in welcher die lichtabsorbierenden Schichten aus pigmentierter Tinte oder Beschichtung oder aus nichtpigmentierter Farbe gebildet sind.

8. Sicherheitsvorrichtung nach einem der vorhergehenden Ansprüche, in welcher das von einer der farbvariablen Schichten bei bestimmten Sichtwinkeln reflektierte Licht in der nicht sichtbaren Wellenlänge des elektromagnetischen Spektrums liegt.

9. Sicherheitsvorrichtung nach einem der vorhergehenden Ansprüche, welche des Weiteren ein maschinenlesbares Element in einer lichtabsorbierenden Schicht oder in einer unabhängigen Schicht aufweist.

10. Sicherheitsvorrichtung nach einem der vorhergehenden Ansprüche, in welcher eine oder beide farbvariablen Schichten Flüssigkristallschichten sind.

11. Sicherheitsvorrichtung nach einem der Ansprüche 1 bis 9, in welcher eine oder beide farbvariablen Schichten mehrschichtige Polymerfilme sind.

12. Sicherheitsdokument, welches ein Substrat und eine Sicherheitsvorrichtung nach einem der vorhergehenden Ansprüche aufweist.

13. Sicherheitsdokument nach Anspruch 12, in welchem die Sicherheitsvorrichtung auf eine Oberfläche des Substrats aufgebracht ist oder zumindest teilweise in das Substrat eingebettet ist, und in Fenstern in mindestens einer Oberfläche des Substrats sichtbar ist.

14. Sicherheitsdokument nach Anspruch 12 oder Anspruch 13, welches einen Beleg, einen Reisepass, eine Banknote, einen Scheck, eine Urkunde oder ein anderes Wertdokument einschließt.

15. Sicherheitsdokument nach einem der Ansprüche 12 bis 14, in welchem das Dokument mit Identifizierungsinformationen bedruckt wird, und Designs, welche durch die Lichtreflektion von den viel größeren Filmen der Sicherheitsvorrichtung gebildet werden, mit den Identifizierungsinformationen in Verbindung gebracht werden.

16. Sicherheitsdokument nach Anspruch 15, in welchem die Verbindung durch Inhalt und/oder Registrierung der Designs erfolgt.

17. Verfahren zur Herstellung einer Sicherheitsvorrichtung nach einem der Ansprüche 1 bis 11, welches die folgenden Schritte aufweist:
Aufbringen der Teilschicht aus lichtabsorbierenden Werkstoffs auf eine erste farbvariable Schicht;
Aufbringen der zweiten farbvariablen Schicht, um die absorbierende Teilschicht und die freiliegenden Bereiche der ersten farbvariablen Schicht zu bedecken; und
Aufbringen einer zweiten Schicht aus lichtabsorbierendem Werkstoff, um eine freiliegende bzw. exponierte Oberfläche der zweiten farbvariablen Schicht zu bedecken.

18. Verfahren zur Herstellung einer Sicherheitsvorrichtung nach Anspruch 17, in welchem eine Schicht aus Metall aufgebracht wird, um die zweite Schicht aus lichtabsorbierendem Werkstoff zu bedecken.

19. Verfahren zur Herstellung einer Sicherheitsvorrichtung nach einem der Ansprüche 17 oder 18, welches des Weiteren den Schritt der Aufbringung einer Schicht aus Klebstoff auf eine oder beide Oberflächen der Vorrichtung umfasst.

## Revendications

1. Dispositif de sécurité, comprenant une première couche de changement de couleur, une deuxième couche de changement de couleur qui présente des caractéristiques de réflexion différentes de la première couche de changement de couleur, lesdites couches de changement de couleur présentant une couleur visible à l'incidence normale, une première couche partielle d'absorption de lumière entre des premières surfaces des première et deuxième couches de changement de couleur et une deuxième couche d'absorption de lumière appliquée à une deuxième surface de la deuxième couche de changement de couleur, où la couleur de la première couche partielle d'absorption est choisie de manière à correspondre sensiblement à la couleur de la lumière réfléchie à un angle d'incidence normal par la combinaison de la deuxième couche de changement de couleur et de la deuxième couche d'absorption.

2. Dispositif de sécurité, comprenant une première couche de changement de couleur, une deuxième couche de changement de couleur qui présente des caractéristiques de réflexion différentes de la première couche de changement de couleur, ladite deuxième couche de changement de couleur étant un polymère multicouche, une première couche partielle d'absorption de lumière entre des premières surfaces des premier et deuxième couches de changement de couleur et une deuxième couche d'absorption de lumière appliquée à une deuxième surface de la deuxième couche de changement de couleur, où la couleur de la première couche partielle d'absorption est choisie de manière à correspondre sensiblement à la couleur de la lumière réfléchie à un angle d'incidence normal par la combinaison de la deuxième couche de changement de couleur et de la deuxième couche d'absorption.

3. Dispositif de sécurité tel que revendiqué dans la revendication 1 ou 2, dans lequel l'une et/ou l'autre des couches de changement de couleur sont/est des/une couche(s) partielle(s).

4. Dispositif de sécurité tel que revendiqué dans l'une quelconque des revendications précédentes, dans lequel la deuxième couche d'absorption de lumière est une couche partielle.

5. Dispositif de sécurité tel que revendiqué dans l'une quelconque des revendications précédentes, dans lequel l'une et/ou l'autre des couches d'absorption de lumière forment/forme des indices.

6. Dispositif de sécurité tel que revendiqué dans la revendication 5, dans lequel les indices comprennent un(e) ou plusieurs parmi un dessin, un motif, des symboles ou des caractères alphanumériques ou l'une de leurs combinaisons.

7. Dispositif de sécurité tel que revendiqué dans l'une quelconque des revendications précédentes, dans lequel les couches d'absorption de lumière sont formées par une encre ou un revêtement pigmenté(e), ou un colorant non-pigmenté.

8. Dispositif de sécurité tel que revendiqué dans l'une quelconque des revendications précédentes, dans lequel la lumière réfléchie par l'une des couches de changement de couleur à certains angles de vue est dans la longueur d'onde non visible du spectre électromagnétique.

9. Dispositif de sécurité tel que revendiqué dans l'une quelconque des revendications précédentes, comprenant en outre un élément lisible par machine dans une couche d'absorption de lumière ou dans une couche indépendante.

10. Dispositif de sécurité tel que revendiqué dans l'une quelconque des revendications précédentes, dans lequel l'une et/ou l'autre des couches de changement de couleur sont/est des/une couche(s) à cristaux liquides.

11. Dispositif de sécurité tel que revendiqué dans l'une quelconque des revendications 1 à 9, dans lequel l'une et/ou l'autre des couches de changement de couleur sont/est des/un film(s) polymère(s) multicouche.

12. Document de sécurité, comprenant un substrat et un dispositif de sécurité tel que revendiqué dans l'une quelconque des revendications précédentes.

13. Document de sécurité tel que revendiqué dans la revendication 12, dans lequel le dispositif de sécurité est appliqué à une surface du substrat, ou est au moins partiellement incorporé dans le substrat et visible dans des fenêtres dans au moins une surface du substrat.

14. Document de sécurité tel que revendiqué dans la revendication 12 ou 13, comprenant un bon d'échange, un passeport, un billet de banque, un chèque, un certificat ou un autre document de valeur.

15. Document de sécurité tel que revendiqué dans l'une quelconque des revendications 12 à 14, dans lequel des informations d'identification sont imprimées sur le document et des dessins formés par réflexion de la lumière à partir les films beaucoup plus grands du dispositif de sécurité sont liés aux informations d'identification.

16. Document de sécurité tel que revendiqué dans la revendication 15, dans lequel le lien est par le contenu et/ou l'enregistrement des dessins.

17. Procédé de fabrication d'un dispositif de sécurité tel que revendiqué dans l'une quelconque des revendications 1 à 11, comprenant les étapes qui consistent :
à appliquer la couche partielle de matériau d'absorption de lumière à une première couche de changement de couleur ;
à appliquer la deuxième couche de changement de couleur pour couvrir la couche partielle d'absorption et les zones exposées de la première couche de changement de couleur ; et
à appliquer une deuxième couche de matériau d'absorption de lumière pour couvrir une surface exposée de la deuxième couche de changement de couleur.

18. Procédé de fabrication d'un dispositif de sécurité tel que revendiqué dans la revendication 17, dans lequel une couche de métal est appliquée pour couvrir la deuxième couche de matériau d'absorption de lumière.

19. Procédé de fabrication d'un dispositif de sécurité tel que revendiqué dans l'une quelconque des revendications 17 ou 18, comprenant en outre l'étape qui consiste à appliquer une couche d'adhésif à l'une et/ou l'autre des surfaces du dispositif.
